(19) **Europäisches Patentamt**
**European Patent Office**
**Office européen des brevets**

(11) **EP 3 381 013 B1**

(12) **FASCICULE DE BREVET EUROPEEN**

(45) Date de publication et mention
de la délivrance du brevet:
**11.02.2026 Bulletin 2026/07**

(21) Numéro de dépôt: **16813082.1**

(22) Date de dépôt: **24.11.2016**

(51) Classification Internationale des Brevets (IPC):
**G06T 7/00** (2017.01)      **G06T 7/30** (2017.01)

(52) Classification Coopérative des Brevets (CPC):
**G06T 7/001; G06T 7/30;** G06T 2207/10081;
G06T 2207/30164

(86) Numéro de dépôt international:
**PCT/FR2016/053082**

(87) Numéro de publication internationale:
**WO 2017/089714 (01.06.2017 Gazette 2017/22)**

(54) **PROCÉDÉ DE CONTRÔLE NON DESTRUCTIF D'UNE PIÈCE POUR AÉRONAUTIQUE**
VERFAHREN ZUR ZERSTÖRUNGSFREIEN PRÜFUNG EINES BAUTEILS FÜR DIE LUFTFAHRT
METHOD OF NON-DESTRUCTIVE CHECKING OF A COMPONENT FOR AERONAUTICS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.11.2015 FR 1561301**

(43) Date de publication de la demande:
**03.10.2018 Bulletin 2018/40**

(73) Titulaire: **SAFRAN**
**75015 Paris (FR)**

(72) Inventeurs:
• **LE GUILLOUX, Yann**
**77550 Moissy-Cramayel (FR)**
• **LASJAUNIAS, Benoît, Vincent, Pierre**
**77550 Moissy-Cramayel (FR)**
• **MORARD, Vincent, Jérôme**
**77550 Moissy-Cramayel (FR)**
• **PARRA, Estelle**
**77550 Moissy-Cramayel (FR)**

(74) Mandataire: **Regimbeau**
**20, rue de Chazelles**
**75847 Paris Cedex 17 (FR)**

(56) Documents cités:
**WO-A1-2011/015822      WO-A1-2015/074158**

• **ALEJANDRO F. FRANGI ET AL: "Multiscale Vessel Enhancement Filtering Heartin4D View project Heart in 3D View project Multiscale vessel enhancement filtering", MEDICAL IMAGE COMPUTING AND COMPUTER-ASSISTEDD INTERVENTION, 13 October 1998 (1998-10-13), XP055590767, Retrieved from the Internet <URL:https://www.researchgate.net/publication/ 2388170_Multiscale_Vessel_Enhancement_Filter ing/download> [retrieved on 20190521]**
• **ZITOVA B ET AL: "IMAGE REGISTRATION METHODS: A SURVEY", IMAGE AND VISION COMPUTING, ELSEVIER, GUILDFORD, GB, vol. 21, no. 11, 1 October 2003 (2003-10-01), pages 977 - 1000, XP001189327, ISSN: 0262-8856, DOI: 10.1016/S0262-8856(03)00137-9**
• **BENJAMIN BECKER ET AL: "Computer Tomography has arrived in automated inspection processes, combining material and geometry analyses", 20 April 2012 (2012-04-20), XP055290657, Retrieved from the Internet <URL:http://www.ndt.net/article/wcndt2012/ papers/306_wcndtfinal00306.pdf> [retrieved on 20160722]**
• **MUHAMMAD MUDDASSIR MALIK ET AL: "Computation and visualization of fabrication artifacts", 1 January 2009 (2009-01-01), XP055290485, Retrieved from the Internet <URL:http://publik.tuwien.ac.at/files/ PubDat_179643.pdf> [retrieved on 20160615]**

- YIPENG HU ET AL: "MR to Ultrasound Image Registration for Guiding Prostate Biopsy and Interventions", 20 September 2009, MEDICAL IMAGE COMPUTING AND COMPUTER-ASSISTED INTERVENTION - MICCAI 2009, SPRINGER BERLIN HEIDELBERG, BERLIN, HEIDELBERG, PAGE(S) 787 - 794, ISBN: 978-3-642-04267-6, XP019130396

- HAITHAM SHAMMAA M ET AL: "Registration of CAD mesh models with CT volumetric model of assembly of machine parts", THE VISUAL COMPUTER ; INTERNATIONAL JOURNAL OF COMPUTER GRAPHICS, SPRINGER, BERLIN, DE, vol. 23, no. 12, 8 August 2007 (2007-08-08), pages 965 - 974, XP019562390, ISSN: 1432-2315, DOI: 10.1007/S00371-007-0171-2

**Description**

DOMAINE TECHNIQUE GENERAL

L'invention concerne le domaine du contrôle non destructif (CND) sur des pièces industrielles, notamment dans le domaine de l'aéronautique, à l'aide de volumes tomographiques numériques par exemple.

Plus précisément, l'invention concerne le recalage (*« registration »* en anglais) de ces volumes sur des modèles réalisés sur ordinateur.

Le CND est primordial pour contrôler la santé matière des matériaux. Par exemple, les aubes de soufflante, qui sont en composite de fibres de carbone tissées en trois dimensions, sont des pièces critiques qui doivent être contrôlées en intégralité. Mais le carter fan, le redresseur, les pales, les aubes, etc. peuvent aussi être concernés.

Les volumes tomographiques numériques sont obtenues à l'aide d'un tomographe dont le générateur de rayons X émet un faisceau traversant la pièce à explorer, avant d'être analysé, après atténuation, par un système de détection. L'image intermédiaire ainsi obtenue est appelée une « projection ». En acquérant une pluralité de projections dans différents plans de l'espace (avec un éventuel prétraitement) et en les recombinant, on obtient un volume tridimensionnel de la pièce avec une valeur de densité d'absorption des rayons X à chaque voxel.

Ces volumes permettent un accès non destructif à l'intérieur de la pièce. Néanmoins, selon la forme de la pièce, l'énergie peut être assez faible et in *fine* le volume peut être mal défini en certains endroits (par exemple les formes concaves, où le gradient est faible).

D'autres technologies d'imagerie sont possibles pour obtenir de tels volumes.

Les modèles réalisés sur ordinateur sont obtenus par Conception Assistée par Ordinateur (CAO, ou CAD pour *« Computer Aided Design »* en anglais) : ce sont des ensembles de surfaces ou courbes paramétré (e)s permettant de décrire d'une façon théorique une pièce.

La CAO de la pièce est par exemple maillée par un ensemble de cellules formant une surface tridimensionnelle.

Dans la suite de la description, on se réfèrera à des volumes obtenus par tomographie.

Les bureaux d'études en charge des pièces citées précédemment définissent des zones de criticité et/ou des zones d'analyse qui sont définies dans le référentiel CAO.

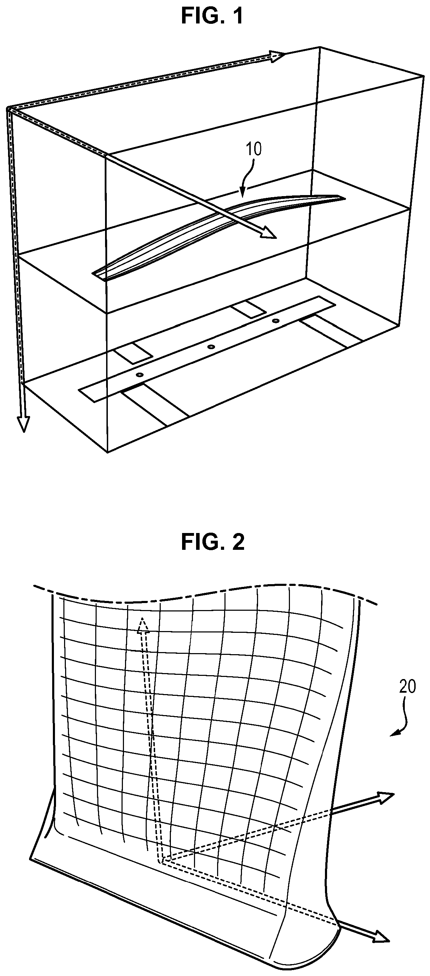

Or, comme le volume tomographique et le modèle CAO possèdent chacun leur propre référentiel (voir **figures 1 et 2),** il est nécessaire de connaitre la transformation permettant de passer d'un référentiel à l'autre pour pouvoir connaitre la position exacte d'une information repérée dans le volume tomographique ou le modèle CAO. Ces méthodes sont appelés « recalage » (*registration* en anglais).

Le recalage cherche donc à faire coïncider au mieux le modèle CAO avec le volume tomographique. En effet, le modèle CAO est moins lourd (en matière de traitement informatique) à déplacer. En outre, des problèmes d'interpolation incitent à déplacer le modèle CAO sur le volume tomographique. La transformation inverse (du repère tomographique vers le repère CAO) peut ensuite être déduite.

On appelle t une transformation permettant de changer de repère entre la surface CAO et le volume tomographique, t appartenant à l'espace des transformations T. En particulier, on s'intéresse à la transformation permettant de passer du repère CAO au repère tomographique.

Dans l'espace T des transformations rigides, t dépend de six paramètres (les trois translations et les trois rotations de l'espace). En revanche, dans l'espace T des transformations élastiques, T peut être de dimension supérieure.

Lors du recalage, on utilise un critère de similitude que l'on cherche à maximiser (ou minimiser un critère de dissimilarité ; par la suite, on supposera qu'on cherche à maximiser un critère de similitude). Le critère de similitude comprend en entrée le volume tomographique et la transformée t(CAO) du modèle CAO par la transformation t. Par la suite, on se réfèrera à la similitude sous la forme S(t(CAO), volume).

Le critère de similitude est choisi de sorte qu'il soit maximal, lorsque la transformation t est celle qui optimise le recalage. A cette fin, il est nécessaire que le critère de similitude soit continu, dérivable et dépourvu de maxima locaux autres que le maximum global dans le voisinage du recalage initial.

Ainsi, le critère d'optimisation est la maximisation de la similitude définie.

Le problème d'optimisation peut être décrit sous la forme suivante, avec $t_{opt}$ la transformation optimale :

$$t_{opt} = \underset{t \in T}{\arg\max} \left[ S(t(CAO), volume) \right]$$

ETAT DE L'ART

Il existe différentes méthodes pour effectuer le recalage.

Une méthode connue consiste à extraire le contour de la pièce dans le volume tomographique pour obtenir à partir d'un volume tridimensionnel une surface. Il s'agit ensuite d'un processus connu de recalage avec la surface CAO, après avoir maillé la surface obtenue depuis le volume tomographique.

Néanmoins, cette méthode présente des limitations.

La précision dépend de la précision d'extraction du contour de la pièce. Or, certaines zones de la pièce reçoivent une énergie très faible, ce qui provoque des contours mal localisés. Cette imprécision se répercute aussi dans l'étape de maillage.

A ces deux sources d'imprécision s'ajoute l'incertitude inhérente aux méthodes de recalage traditionnelles.

En outre, cette méthode applique le même poids à toutes les zones de la pièce, quelles que soient ses formes. Par exemple, les zones mal définies et/ou présentant un intérêt moindre sont autant prises en considération que les bords convexes, plus détaillés, pour l'étape de recalage.

PRESENTATION DE L'INVENTION

On souhaite par conséquent une méthode qui permette de pallier les inconvénients précités.

L'invention propose un procédé de contrôle non-destructif d'une pièce pour aéronautique, le procédé comprenant les étapes suivantes de :

- acquisition par imagerie tomographique d'un volume correspondant à une pièce à analyser,
- génération par simulation informatique d'une surface correspondant à la pièce à analyser,
- calcul d'un champ de gradient du volume et génération d'un champ de vecteur normaux à ladite surface,
- recalage du volume et de la surface en optimisant un critère de similitude défini par une fonction prenant en compte la corrélation entre les vecteurs normaux du champ de vecteurs normaux de la surface déplacée par une transformation et le gradient du champ de gradient du volume, ladite optimisation étant effectuée en fonction des transformations pour déterminer la transformation optimale qui maximise le critère de similitude,
- mémorisation de la transformation optimale,
- établissement de la correspondance entre la surface et le volume obtenu à l'aide de la transformation optimale,

les étapes de recalage, mémorisation et d'établissement de la correspondance étant mises en œuvre par une unité de calcul comprenant des moyens de traitement de données.

Alors qu'il est connu de comparer un volume avec un autre volume ou une surface avec une autre surface, l'invention a recours à une méthode de recalage inter-modalité volume/surface, qui permet de s'affranchir des limitations de l'art antérieur. Pour cela, un critère de similitude original entre deux objets hétérogènes est présenté, basé sur la corrélation des normales de la surface CAO avec les gradients du volume.

En utilisant un calcul de champ de gradient du volume, on s'affranchit de l'extraction de la surface du volume et du calcul de vecteurs normaux à cette surface.

La comparaison du gradient sur le volume tomographique avec les normales à la surface permet de faire le lien entre les deux modalités. Le calcul par exemple d'une fonction des produits scalaires des deux champs de vecteurs permet d'obtenir une fonction de similitude très robuste au bruit et donc très précise.

On obtient alors une méthode qui ne cumule pas les erreurs d'extraction du contour du volume et de maillage du contour.

Préférablement, le volume est obtenu par tomographie à rayons X.

Avantageusement, l'invention comprend les caractéristiques suivantes, prises seules ou en combinaison :

- la surface comprend un maillage composé de cellules, dans lequel les vecteurs normaux sont définis par rapport auxdites cellules,
- le gradient du volume est défini en fonction de la densité des voxels formant ledit volume,
- le critère de similitude utilise une fonction des produits scalaires entre les normales de la surface et les gradients du volume aux points considérés,
- la fonction est une somme des produits scalaires,
- la fonction est une somme quadratique des produits scalaires,
- le procédé comprend une étape de pré-recalage à l'aide des données issues d'une acquisition du volume, l'étape de pré-recalage étant effectuée après les étapes d'acquisition du volume et de génération de la surface mais avant l'étape de recalage,
- l'étape de pré-recalage associe à chaque vecteur normal de la surface un vecteur gradient du volume associé à un voxel ou une pluralité de voxels, les deux vecteurs formant un couple de vecteurs, et dans lequel le critère de similitude de l'étape de recalage prend en compte la corrélation entre les deux vecteurs du couple,
- la pièce est une pièce destinée à équiper un aéronef.

PRESENTATION DES FIGURES

D'autres caractéristiques, buts et avantages de l'invention ressortiront de la description qui suit, qui est purement illustrative et non limitative, et qui doit être lue en regard des dessins annexés, sur lesquels :

- La figure 1 représente une vue tomographique d'une aube, dont l'origine du repère est située dans le coin supérieur gauche,
- La figure 2 représente une vue réalisée par conception assistée par ordinateur (CAD) d'une aube, dont l'origine du repère est située au milieu de l'aube en sortie de portée,
- La figure 3 représente des vecteurs normaux sur une pièce simulée par CAO,
- Les figures 4a et 4b représentent des illustrations d'un algorithme d'optimisation du recalage,
- La figure 5 représente un diagramme symbolisant différentes étapes intervenant dans le processus global du contrôle non destructif selon un mode de réalisation de l'invention.

DESCRIPTION DETAILLEE

La méthode décrite ici permet le contrôle d'un volume tomographique numérique 10 obtenue par tomographie à rayons X d'une pièce **(figure 1)** et d'un modèle CAO 20 sous forme d'une surface **(figure 2)** obtenue par simulation informatique de cette même pièce. Cette méthode comprend un recalage entre le volume et la surface transformée par une transformation t dont on cherche l'optimum $t_{opt}$.

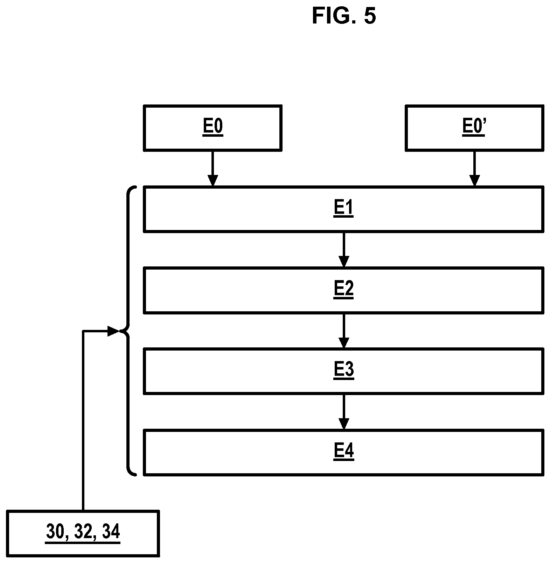

La **figure 5** schématise certaines étapes.

Il s'agit typiquement d'une pièce destinée à l'industrie aéronautique.

La méthode s'applique à tout type de volume tridimensionnel obtenu par d'autres technologies d'imagerie, pour lesquelles un champ de gradient peut être calculé (voir *infra*).

L'objectif du recalage est d'obtenir la transformation optimale $t_{opt}$ permettant de faire coïncider le plus possible le volume 10 et la surface 20.

Une étape préliminaire E0 à toute méthode de recalage consiste à acquérir le volume tomographique à l'aide d'un dispositif d'imagerie tomographique. Une autre étape préliminaire E0' consiste à générer la surface CAO 20 par informatique, à l'aide de moyens de calcul. La surface CAO 20 ainsi générée est orientée.

Le processus de recalage, présenté en introduction, est effectué par une unité de calcul 30 comprenant des moyens de traitement de données 32. Par exemple, l'unité de calcul 30 est un ordinateur personnel ou un calculateur adapté, et les moyens de traitement de données 32 sont des processeurs. L'unité de calcul 30 peut servir à générer la surface CAO 20.

Le processus de recalage comprend notamment deux étapes principales E1 et E2.

On peut si besoin définir une étape intermédiaire de réception par l'unité de calcul 30 du volume 10 et de la surface 20.

Une première étape principale E1, dite de pré-recalage, consiste en une initialisation grossière du recalage et la deuxième étape principale E2 consiste en l'optimisation dudit recalage. En effet, l'application d'algorithme de recalage n'est pas toujours pertinente si l'extremum n'est pas à proximité. Suite à cette étape de pré-recalage, la superposition est dans un voisinage de l'optimum, ce qui permettra d'appliquer ensuite un méthode d'optimisation de recalage.

La première étape E1 est typiquement effectuée grâce à l'ensemble des données systèmes fournies par le tomographe. Lors de l'acquisition des données, la géométrie du montage (distance entre le tube du tomographe et le détecteur, entre le tube et la pièce, les angles, etc.) et l'ensemble des paramètres liés à la reconstruction sont renseignés. Cette initialisation du recalage est connue de l'homme du métier et ne sera pas détaillée ici. A l'issue de cette première étape E1, le volume tomographique 10 et la surface CAO 20 sont positionnés relativement l'un par rapport à l'autre et le recalage est au voisinage de l'optimum.

La deuxième étape E2 est effectuée à l'aide d'un critère de similitude S tel que présenté en introduction.

Pour chaque transformation t, on obtient une valeur de la similitude S(t(CAO), volume).

Comme indiqué en introduction, il s'agit d'optimiser la transformation t pour obtenir le maximum global du critère de similitude S.

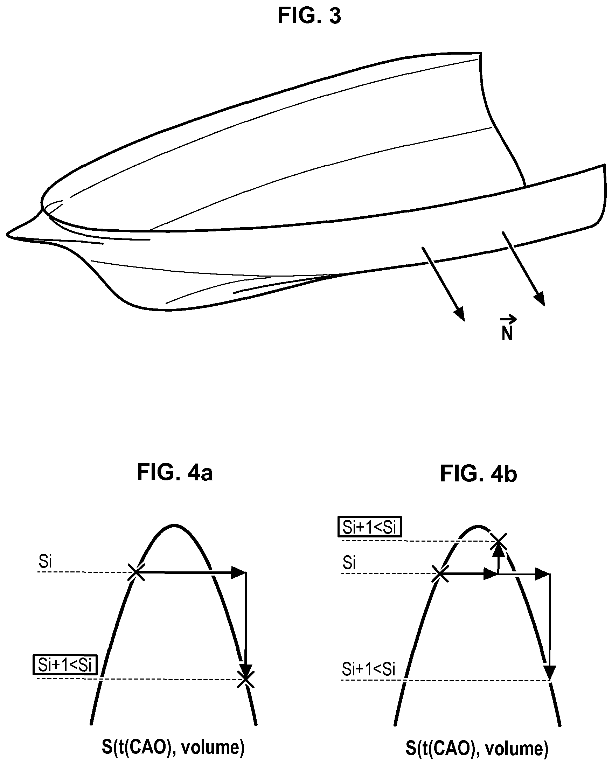

Afin de tenir compte à la fois du volume tomographique 10 et de la surface CAO 20, le critère de similitude S est fondé sur une fonction exprimant la corrélation entre des vecteurs normaux N de la surface 20 transformée t(CAO) (par la transformation t) et des gradients du volume tomographique 20, aux points considérés (voir **figure 3)**.

Par conséquent, même si les données d'entrée consistent en un volume et une surface, le procédé utilise des gradients et des vecteurs normaux qui sont des données homogènes pouvant être combinées pour obtenir un critère de similitude fonctionnel (i.e. le maximum local identifiable est pertinent).

Avant l'étape E2 de recalage proprement dite, le procédé comprend ainsi une étape E01 de calcul d'un champ de gradients sur le volume tomographique 10 et une étape E01' de génération d'un champ de vecteurs normaux sur la surface 20. Le calcul du champ de gradient sur le volume tomographique permet de contourner l'étape d'extraction de la surface dudit volume et ses imprécisions liées. Ces étapes sont mises en œuvre par une unité de calcul, typiquement l'unité 30.

Le champ des vecteurs normaux N de la surface CAO 20 est décrit par des paires point/vecteur normal en chaque point considéré. Pour chaque point considéré, cette paire point/vecteur normal est transformée par la transformation t dans le repère du volume tomographique 10 et associée au gradient correspondant dans ce repère (préférablement pré-calculé). La corrélation est ensuite effectuée.

Pour les voxels situés sur la surface de l'objet, le gradient du volume tomographique 10 est orthogonal à la surface de l'objet et, en cas de superposition idéale, le deux champs de vecteurs, celui des normales à la surface du modèle CAO et celui des gradients du volume tomographique aux points correspondants, sont confondus. Or, comme un champ de vecteurs normaux (et donc un champ de gradient) caractérise une surface, la superposition des champs permet d'assurer que la surface 20 transformée t(CAO) est superposée sur le volume 10.

Dans le cas d'un maillage 22 composés de cellules 24, les vecteurs normaux N sont définis par rapport aux cellules 24 du maillage 22. Les cellules 24 du maillage 22 sont préférablement des polygones plans, et plus particulièrement des triangles. Dans le cas d'un polygone plan, le vecteur normal est classiquement défini comme un vecteur s'étendant orthogonalement vers l'extérieur depuis la surface plane de ladite cellule.

Le critère de similitude S prend ainsi en compte le vecteur normal N à un point considéré, c'est-à-dire à une cellule 24 du maillage 22 associée au gradient défini pour une zone du volume 10 correspondante (par exemple un voxel ou une pluralité de voxels voisins). On définit ainsi un couple gradient/vecteur normal pour chaque point considéré (i.e. chaque partie) de la surface CAO 20 transformée t(CAO), qui ont été préalablement sensiblement superposées de façon peu précise lors de l'étape E1 (on était alors dans un voisinage de la valeur maximale du critère de similitude).

Si la surface CAO transformée t(CAO) est superposée (de façon exacte ou quasi-exacte) au volume 10, tous ces couples de vecteurs sont colinéaires.

Par conséquent, le critère de similitude S doit être maximum lorsque tous ces couples de vecteurs sont colinéaires.

Pour cela, dans un mode de réalisation préférentiel, la corrélation du critère de similitude S est définie par un produit scalaire entre les vecteurs normaux N et les gradients de chaque couple de vecteur considéré. On peut typiquement sommer l'ensemble des produits scalaires.

Un exemple de fonction pour la similitude S est une somme, ou une somme quadratique, des produits scalaires sur l'ensemble des points considérés, c'est-à-dire que l'on somme le carré des produits scalaires des couples de vecteurs gradients/normaux considérés.

Une similitude faisant intervenir une fonction du cosinus de l'angle entre le couple de vecteur est ici assimilée à un produit scalaire.

Un produit scalaire étant maximum lorsque les deux vecteurs sont colinéaires et de même sens, on comprend bien que la similitude S est maximum quand tous les couples de vecteurs sont colinéaires et de même sens, c'est-à-dire que la surface 20 est superposée sur le volume 10.

Les trois composantes du gradient du volume 10 sont calculées à partir de différences de densité d'absorption entre différents voxels du volume 10 selon les trois axes.

En outre, la méthode accorde intrinsèquement davantage d'importance aux zones de fort gradient de la pièce. En effet, plus le gradient est important, et plus il aura de poids dans la sommation de l'ensemble des produits scalaires des couples de vecteurs. Cela est un gage de robustesse car les gradients plus forts sont mieux définis et plus stables.

Alternativement, si on souhaite accorder le même poids à toutes les zones de la pièce, il suffit de normaliser les gradients (et les vecteurs normaux s'ils ne le sont pas) avant d'appliquer le critère de similitude présenté précédemment.

Le critère de similitude présenté ci-dessus permet l'obtention d'une valeur de similitude pour chaque transformation t. Le processus de recalage utilise ensuite des étapes d'affinement de ce critère de similitude en fonction de la transformation t.

La première valeur du critère de similitude S

calculée pour commencer l'optimisation est celle de la transformée qui résulte de l'étape de pré-recalage E1.

Dans le cas de transformations rigides, on rappelle qu'une transformation t telle que définie précédemment est décrite par 6 paramètres : les trois translations et les trois rotations de l'espace.

La maximisation (ou minimisation) de la similitude peut être réalisée par différents algorithmes.

En particulier, la similitude fait intervenir le gradient du volume, sa dérivée spatiale fait donc intervenir la dérivée seconde du volume, à savoir sa Hessienne. Après avoir calculé la Hessienne du volume en chaque point, on peut donc utiliser par exemple un algorithme de montée de gradient pour maximiser la similitude et en déduire la transformation optimale.

Le gradient de la similitude par rapport aux modifications de transformations t est de dimension 6 (variations pour les trois rotations et pour les trois translations) On se déplace donc selon la direction de ce gradient, présentant la plus grande pente (positive) de variation (dans l'espace tangent à celui des transformations) Les **figures 4a et 4b** symbolisent cette méthode. En ordonnée est représentée la valeur de la similitude S et en abscisse est représentée la direction du gradient présentant la plus grande pente de variation de la similitude.

Entre chaque calcul de la valeur de la similitude, la transformation t est modifiée d'une certaine valeur appelée « pas ». Le « pas » est typiquement un vecteur à six coordonnées, correspondant à un déplacement donné et une rotation donnée dans l'espace. L'indice $i$ se rapporte aux itérations.

La méthode est donc la suivante :

- E21 : Calcul de la valeur de similitude pour une transformation ti : $S(t_i(CAO), volume)$, notée $S_i$ sur les **figures 4a et 4b**,
- E22 : Calcul de la valeur de similitude pour une transformation $t_{i+1}$ incrémentée du pas : $S(t_{i+1}(CAO), volume)$, notée $S_{i+1}$ sur les **figures 4a et 4b,**
- E23 : comparaison des valeurs :

    ∘ si $S(t_{i+1}(CAO), volume) > S(t_i(CAO), volume)$, alors on répète l'étape E22 à partir de la nouvelle transformation $t_{i+1}$,
    ∘ si $S(t_{i+1}(CAO), volume) < S(t_i(CAO), volume)$, alors on attribue au pas une nouvelle valeur inférieure et on effectue l'étape E22 à partir de la transformation $t_i$ incrémentée du nouveau pas.

Par exemple, la nouvelle valeur du pas correspond au pas divisé par deux.

La répétition de l'étape E21 n'est par ailleurs pas nécessaire puisque la valeur a déjà été calculée lors d'une occurrence précédente de l'étape.

Si le pas devient inférieur à un seuil choisi, l'algorithme s'arrête.

De même, si la valeur de la similitude n'évolue pas suffisamment, l'algorithme s'arrête. On estime alors qu'on a trouvé la transformation optimale $t_{opt}$.

Les critères d'arrêt ou de modification de l'algorithme peuvent être ajustés en fonction des besoins.

D'autres méthodes existent pour optimiser le critère de similitude :

- Algorithme de Levenberg Marquardt,
- Broyden-Fletcher-Goldfarb-Shanno,
- Fletcher-Reeves,
- Polaak-Robiere.

A l'issue de l'étape E2 d'optimisation, la transformation optimale $t_{opt}$ est mémorisée dans une étape E3. Pour cela, l'unité de calcul 30 est dotée d'une mémoire 34.

Enfin, dans une étape E4, grâce à la transformation optimale, on peut établir une correspondance entre le volume 10 et la surface 20.

L'étape E4 peut comprendre le calcul de l'inverse de la transformation optimale, afin d'obtenir la transformation optimale inverse, c'est-à-dire la transformation qui permet de superposer le volume 10 sur la surface 20.

Grâce à cette correspondance entre la surface CAO 20 et le volume obtenue par imagerie de la pièce réelle, il est possible d'opérer des vérifications précises sur la santé matière de la pièce.

**Revendications**

1. Procédé de contrôle non-destructif d'une pièce pour aéronautique, le procédé comprenant les étapes suivantes de :

   - (E0) acquisition par imagerie tomographique d'un volume (10) correspondant à une pièce à analyser,
   - (E0') génération par simulation informatique d'une surface (20) correspondant à la pièce à analyser,
   - (E01 et E01') calcul d'un champ de gradient du volume (10) et génération d'un champ de vecteur normaux (N) à ladite surface (20),
   - (E2) recalage du volume (10) et de la surface (20) en déplaçant le champ de vecteur normaux (N) par plusieurs transformations (t), en effectuant, pour chaque transformation (t), une corrélation entre les vecteurs normaux (N) du champ de vecteurs normaux déplacé et les gradients correspondants du champ de gradient du volume (10), et en optimisant un critère de similitude (S) défini par une fonction prenant en compte la corrélation effectuée, ladite optimisation étant effectuée en fonction des transformations (t) pour déterminer la transformation optimale ($t_{opt}$) qui maximise le critère de similitude (S),
   - (E3) mémorisation de la transformation optimale ($t_{opt}$),
   - (E4) établissement de la correspondance entre la surface (10) et le volume obtenu à l'aide de la transformation optimale (20),

   les étapes de recalage (E2), mémorisation (E3) et d'établissement de la correspondance (E4) étant mises en œuvre par une unité de calcul (30) comprenant des moyens de traitement de données (32).

2. Procédé selon la revendication 1, dans lequel la surface (20) comprend un maillage (22) composé de cellules (24), dans lequel les vecteurs normaux (N) sont définis par rapport auxdites cellules (24).

3. Procédé selon l'une quelconque des revendications précédentes, dans lequel le gradient du volume (10) est défini en fonction de la densité des voxels formant ledit volume (10).

4. Procédé selon l'une quelconque des revendications précédentes, dans lequel le critère de similitude (S) utilise une fonction des produits scalaires entre les normales (N) de la surface (20) et les gradients du volume (10) aux points considérés.

5. Procédé selon la revendication 4, dans lequel ladite fonction est une somme des produits scalaires.

6. Procédé selon la revendication 4, dans lequel ladite fonction est une somme quadratique des produits scalaires.

7. Procédé selon l'une quelconque des revendications précédentes, comprenant une étape (E1) de pré-recalage à l'aide des données issues d'une acquisition du volume (10), l'étape de pré-recalage étant effectuée après les étapes d'acquisition du volume (E0) et de génération de la surface (E0') mais avant l'étape de recalage (E2), la première valeur du critère de similitude (S) calculée pour commencer l'optimisation étant celle de la transformée (t) qui résulte de l'étape de pré-recalage (E1).

8. Procédé selon la revendication précédente, dans lequel l'étape de pré-recalage (E1) associe à chaque vecteur normal (N) de la surface (20) un vecteur gradient du volume (20) associé à un voxel ou une pluralité de voxels, les deux vecteurs formant un couple de vecteurs, et dans lequel le critère de similitude de l'étape de recalage (E2) prend en compte la corrélation entre les deux vecteurs du couple.

**9.** Procédé selon l'une quelconque des revendications précédentes, dans lequel la pièce est une pièce destinée à équiper un aéronef.

**10.** Procédé selon l'une quelconque des revendications précédentes, dans lequel l'étape de recalage (E2) est effectuée sans extraction de surface à partir du volume (10).


**Patentansprüche**

**1.** Verfahren zur zerstörungsfreien Prüfung eines Bauteils für die Luftfahrt, wobei das Verfahren die folgenden Schritte umfasst:

- (E0) Erfassung eines Volumens (10), das einem zu analysierenden Bauteil entspricht, mittels tomografischer Bildgebung,
- (E0') Erzeugung einer Oberfläche (20), die dem zu analysierenden Bauteil entspricht, mittels Computersimulation,
- (E01 und E01') Berechnung eines Gradientenfeldes des Volumens (10) und Erzeugen eines Normalenvektorfeldes (N) auf der Oberfläche (20),
- (E2) Registrierung des Volumens (10) und der Oberfläche (20) durch Verschieben des Normalenverktorfeldes (N) durch mehrere Transformationen (t), durch Ausführen, für jede Transformation (t), einer Korrelation zwischen den Normalenvektoren (N) des verschobenen Normalenvektorfeldes und den entsprechenden Gradienten des Gradientenfeldes des Volumens (10) und durch Optimieren eines durch eine Funktion definierten Ähnlichkeitskriteriums (S), die die durchgeführte Korrelation berücksichtigt, wobei die Optimierung in Abhängigkeit von den Transformationen (t) durchgeführt wird, um die optimale Transformation ($t_{opt}$) zu bestimmen, die das Ähnlichkeitskriterium (S) maximiert,
- (E3) Speicherung der optimalen Transformation ($t_{opt}$),
- (E4) Erstellung der Entsprechung zwischen der Oberfläche (10) und dem mit Hilfe der optimalen Transformation (20) erhaltenen Volumen,

wobei die Schritte der Registrierung (E2), der Speicherung (E3) und der Erstellung der Entsprechung (E4) von einer Recheneinheit (30) durchgeführt werden, die Datenverarbeitungsmittel (32) umfasst.

**2.** Verfahren nach Anspruch 1, wobei die Oberfläche (20) ein aus Zellen (24) bestehendes Gitter (22) umfasst, in dem die Normalenvektoren (N) in Bezug auf die Zellen (24) definiert sind.

**3.** Verfahren nach einem der vorstehenden Ansprüche, wobei der Gradient des Volumens (10) in Abhängigkeit von der Dichte der Voxel definiert ist, die das Volumen (10) bilden.

**4.** Verfahren nach einem der vorstehenden Ansprüche, wobei das Ähnlichkeitskriterium (S) eine Funktion der Skalarprodukte zwischen den Normalen (N) der Oberfläche (20) und den Gradienten des Volumens (10) an den betrachteten Punkten verwendet.

**5.** Verfahren nach Anspruch 4, wobei die Funktion eine Summe der Skalarprodukte ist.

**6.** Verfahren nach Anspruch 4, wobei die Funktion eine quadratische Summe der Skalarprodukte ist.

**7.** Verfahren nach einem der vorstehenden Ansprüche, umfassend einen Vorregistrierungsschritt (EI) mit Hilfe der Daten aus einer Erfassung des Volumens (10), wobei der Vorregistrierungsschritt nach den Schritten der Erfassung des Volumens (E0) und der Erzeugung der Oberfläche (E0'), aber vor dem Schritt der Registrierung (E2) durchgeführt wird, wobei der erste Wert des Ähnlichkeitskriteriums (S), der berechnet wurde, um die Optimierung zu beginnen, der Wert der Transformation (t) ist, der aus dem Vorregistrierungsschritt (E1) resultiert.

**8.** Verfahren nach vorstehendem Anspruch, wobei der Vorregistrierungsschritt (EI) jedem Normalenvektor (N) der Oberfläche (20) einen Gradientenvektor des Volumens (20) zuordnet, der einem Voxel oder einer Vielzahl von Voxeln zugeordnet ist, wobei die beiden Vektoren ein Vektorpaar bilden, und wobei das Ähnlichkeitskriterium des Schritts der Registrierung (E2) die Korrelation zwischen den beiden Vektoren des Paares berücksichtigt.

**9.** Verfahren nach einem der vorstehenden Ansprüche, wobei das Bauteil ein Bauteil ist, das zur Ausstattung eines Flugzeugs bestimmt ist.

**10.** Verfahren nach einem der vorstehenden Ansprüche, wobei der Schritt der Registrierung (E2) ohne Extraktion einer Oberfläche ausgehend vom Volumen (10) durchgeführt wird.


**Claims**

**1.** A non-destructive checking method of a part for aeronautics, the method comprising the following steps consisting of:

- (E0) acquisition by tomographic imaging of a volume (10) corresponding to a part to be analyzed,

- (E0') generation by computer simulation of a surface (20) corresponding to the part to be analyzed,
- (E01 and E01') calculation of a field gradient of the volume (10) and generation of a field of normal vectors (N) to said surface (20),
- (E2) registration of the volume (10) and of the surface (20) by moving the normal vector field (N) through several transformations (t), performing, for each transformation (t), a correlation between the normal vectors (N) of the displaced normal vector field and the corresponding gradients of the gradient field of the volume (10), and optimizing a similitude criterion (S) defined by a function taking into account the correlation performed, said optimization being accomplished as a function of the transformations (t) for determining the optimal transformation ($t_{opt}$) which maximizes the similitude criterion (S),
- (E3) storing the optimum transformation ($t_{opt}$) in memory,
- (E4) establishing the correspondence between the surface (10) and the volume obtained by means of the optimal transformation (20),

the registration (E2), memory storage (E3) and establishment of correspondence (E4) steps being implemented by a computation unit (30) comprising data processing means (32).

2. The method according to claim 1, wherein the surface (20) comprises a meshing (22) composed of cells (24) wherein the normal vectors (N) are defined with respect to said cells (24).

3. The method according to any one of the preceding claims, wherein the gradient of the volume (10) is defined as a function of the density of voxels forming said volume (10).

4. The method according to any one of the preceding claims, wherein the similitude criterion (S) uses a function of the scalar products between the normals (N) to the surface (20) and the gradients of the volume (10) and the points considered.

5. The method according to claim 4, wherein said function is a sum of scalar products.

6. The method according to claim 4, wherein said function is a quadratic sum of scalar products.

7. The method according to any one of the preceding claims, comprising a pre-registration step (E1) using data originating in an acquisition of the volume (10), the pre-registration step being accomplished after the volume (10) acquisition step (E0) and surface generation step (E0') but before the registration step (E2), the first value of the similarity criterion (S) calculated to begin optimisation being that of the transform (t) resulting from the pre-registration step (E1).

8. The method according to the preceding claim, wherein the pre-registration step (E1) associates with each normal vector (N) of the surface (10) a vector gradient of the volume (20) associated with a voxel or a plurality of voxels, both vectors forming a couple of vectors, and wherein the similarity criterion of the registration step (E2) takes into account the correlation between the two vectors of the couple.

9. The method according to any one of the preceding claims, wherein the part is a part designed to equip an aircraft.

10. The method according to any one of the preceding claims, wherein the registration step (E2) is performed without extracting a surface from the volume (10).

## FIG. 1

## FIG. 2

**FIG. 3**

**FIG. 4a**

Si

Si+1<Si

S(t(CAO), volume)

**FIG. 4b**

Si+1<Si

Si

Si+1<Si

S(t(CAO), volume)

# FIG. 5